(19) Europäisches Patentamt
European Patent Office
Office européen des brevets

(11) Publication number: **0 111 327**
**B1**

(12) # EUROPEAN PATENT SPECIFICATION

(45) Date of publication of patent specification: **29.06.88**

(51) Int. Cl.$^4$: **H 05 K 1/03,** C 08 L 79/08

(21) Application number: **83112378.1**

(22) Date of filing: **08.12.83**

(54) **A composition useful for making circuit board substrates.**

(30) Priority: **09.12.82 US 448376**

(43) Date of publication of application:
**20.06.84 Bulletin 84/25**

(45) Publication of the grant of the patent:
**29.06.88 Bulletin 88/26**

(84) Designated Contracting States:
**AT BE CH DE FR GB IT LI LU NL SE**

(56) References cited:
**EP-A-0 033 394**
**FR-A-2 482 116**
**US-A-3 518 067**
**US-A-3 658 938**
**US-A-4 049 613**

(73) Proprietor: **AMOCO CORPORATION**
**200 East Randolph Drive P.O. Box 5910-A**
**Chicago Illinois 60680 (US)**

(72) Inventor: **Harris, James Elmer**
**211 Birchview Drive**
**Piscataway New Jersey 08854 (US)**

(74) Representative: **Weinhold, Peter, Dr. et al**
**Patentanwälte Dr. V. Schmied-Kowarzik Dipl.-Ing. G. Dannenberg Dr. P. Weinhold Dr. D. Gudel Dipl.-Ing. S. Schubert Dr. P. Barz**
**Siegfriedstrasse 8**
**D-8000 München 40 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

This invention is directed to a circuit board substrate comprising a blend of poly(aryl ether) and poly(etherimide) polymer, and optionally a fiber and/or a filler. EP—A—33394 is directed to a molding composition comprising a blend of polyarylether resin and a polyetherimide resin. These compositions have improved environmental stress crack resistance. However, at no place is the use of the described molding compositions for making circuit board substrates mentioned.

U.S. Patent 4,281,038 describes a non-conductive substrate (board) for a printed circuit made from a thermoplastic selected from polyphenyloxide, polyphenylsulfide polyimide and polyethersulfone. The thermoplastic has dispersed therein discrete particles of a material such as iron, copper, compounds of iron and compounds of copper which have a coating of a bonding assistant such as a silicone resin, an organic silane and a silane ester.

Circuit boards are widely used in the electrical industry for radio, television, computers, appliances, industrial and electronic equipment. Printed circuit boards have been traditionally manufactured from a copper clad epoxy-glass laminate. When starting with this material the shape of the printed circuit board must first be routed out and the holes for mounting the components (e.g., transistors, resistors, integrated circuits, etc.) individually drilled. The board is then masked with photoresist, the circuitry imaged, and the copper etched away from areas where it is not wanted. An alternative to this procedure is to injection mold the circuit board substrate with the holes in place. The molded substrate is then put through several adhesion promotion steps and plated with electroless copper according to standard technology, to produce the printed circuit board. In this case the substrate material is limited to thermoplastic resins with sufficient thermal stability and chemical properties to survive wave soldering. Also, savings may result which these injection molded circuit board substrates due to the elimination of considerable mechanical processing such as routing and drilling.

The critical parameters of a printed circuit board, from a soldering standpoint, are its heat distortion temperature, environmental stress crack resistance and thermal expansion coefficient. The higher a substrate's heat distortion temperature and environmental stress crack resistance to solder fluxes, the less likely it will blister or delaminate during soldering.

When a poly(aryl ether) based on bisphenol A is molded into a circuit board substrate it has a heat distortion temperature which is generally too low for soldering temperatures such as those encountered in wave soldering. A circuit board substrate molded from poly(etherimide) polymer is resistant to specific etching solutions (e.g., dimethylformamide, or chromic acid) and is thus harder to prepare suitable surfaces for plating. Additionally, circuit boards molded from poly(etherimide) polymers do not have, in many instances, acceptable plateability. Acceptable plateability requires good adhesion of electrolessly plated copper to the substrate.

Object of the present invention is to provide a circuit board substrate which has improved plateability, especially improved peal strength of the plated polymer, and adequate heat distortion temperatures and susceptibility to chromic acid etching.

Subject matter of the invention is a circuit board substrate comprising a blend of 10 to 60 weight percent of a poly(arylether) and 40 to 90 weight percent of a poly(etherimide) polymer.

According to a special embodiment the circuit board substrate contains additionally 5 to 40 weight percent of a fiber and/or 15 to 40 weight percent of a filler.

The composition used for making circuit board substrates comprises preferably from 50 to 85 weight percent of a poly(etherimide), preferably from 15 to 50 weight percent of poly(arylether) polymer and preferably from 10 to 20 weight percent of fiber.

The poly(arylether) polymer may be described as a linear, thermoplastic polyarylene polyether wherein the arylene units are interspersed with other ether, sulfone or ketone linkages. These polymers may be obtained by reaction of an alkali metal double salt of a dihydric phenol and a dihalobenzenoid or dinitrobenzenoid compound, either or both of which contain a sulfone or a ketone linkage, i.e., —$SO_2$— or —CO—, between arylene groupings, to provide sulfone or ketone units in the polymer chain in addition to arylene units and ether units. The polymer has a basic structure comprising recurring units of the formula: O—E—O—E' wherein E is the residuum of the dihydric phenol and E' is the residuum of the benzenoid compound having an inert electron withdrawing group in at least one of the positions ortho and para to the valence bonds; both of said residua are valently bonded to the ether oxygens through aromatic carbon atoms. Such aromatic polyethers are included within the class of polyarylene polyester resins described in, for example, U.S. Patents 3,264,536 and 4,175,175. It is preferred that the dihydric phenol be a weakly acidic dinuclear phenol such as, for example, the dihydroxyl diphenyl alkanes or the nuclear halogenated derivatives thereof, such as, for example, 2,2-bis(4-hydroxyphenyl)propane, 1,1-bis(4-hydroxyphenyl)2-phenyl ethane bis(4-hydroxyphenyl)methane, or their chlorinated derivatives containing one or two chlorines on each aromatic ring. Other materials also termed appropriately "bisphenols" are also highly valuable and preferred. These materials are the bisphenols of a symmetrical or unsymmetrical joining group, as, for example, ether oxygen (—O—),

$$\text{carbonyl } (\text{—}\overset{\overset{\displaystyle O}{\|}}{C}\text{—}),\quad \text{sulfone } (\text{—}\underset{\underset{\displaystyle O}{\|}}{\overset{\overset{\displaystyle O}{\|}}{S}}\text{—}),$$

or hydrocarbon residue in which the two phenolic nuclei are joined to the same or different carbon atoms of the residue.

Such dinuclear phenols can be characterized as having the structure:

$$\begin{array}{ccc} & (A_1)_a & & (A_2)_b \\ & | & & | \\ HO( & Ar & —R_1— & Ar)OH \end{array}$$

wherein Ar is an aromatic group and preferably is a phenylene group, $A_1$ and $A_2$ can be the same or different inert substituent groups such as alkyl groups having from 1 to 4 carbons atoms, halogen atoms, i.e., fluorine, chlorine, bromine or iodine, or alkoxyl radicals having from 1 to 4 carbon atoms, a and b are integers having a value from 0 to 4, inclusive, and $R_1$ is representative of a bond between aromatic carbon atoms as in dihydroxyl-diphenyl, or is a divalent radical, including for example, radicals such as

$$\text{—}\overset{\overset{\displaystyle O}{\|}}{C}\text{—},$$

—O—, —S—, —SO—, —S—S—, —$SO_2$, and divalent hydrocarbon radicals such as alkylene, alkylidene, cycloalkylene, cycloalkylidene, or the halogen, alkyl, aryl or like substituted alkylene, alkylidene and cycloaliphatic radicals as well as aromatic radicals and rings fused to both Ar groups.

Examples of specific dihydric polynuclear phenols including among others: the bis-(hydroxyphenyl) alkanes such as

2,2-bis-(4-hydroxyphenyl)propane,
2,4'-dihydroxydiphenylmethane,
bis-(2-hydroxyphenyl)methane,
bis-(4-hydroxyphenyl)methane,
bis(4-hydroxy-2,6-dimethyl-3-methoxyphenyl)methane,
1,1-bis-(4-hydroxyphenyl)ethane,
1,2-bis-(4-hydroxyphenyl)ethane,
1,1-bis-(4-hydroxy-2-chlorophenyl)ethane,
1,1-bis-(3-methyl-4-hydroxyphenyl)propane,
1,3-bis-(3-methyl-4-hydroxyphenyl)propane,
2,2-bis-(3-phenyl-4-hydroxyphenyl)propane,
2,2-bis-(3-isopropyl-4-hydroxyphenyl)propane,
2,2-bis-(2-isopropyl-4-hydroxyphenyl)propane,
2,2-bis-(4-hydroxy-naphthyl)-propane.
2,2-bis-(4-hydroxyphenyl)pentane,
3,3-bis-(4-hydroxyphenyl)pentane,
2,2-bis-(4-hydroxyphenyl)heptane,
bis-(4-hydroxyphenyl)phenylmethane,
2,2-bis-(4-hydroxyphenyl)-1-phenyl-propane,
2,2-bis-(4-hydroxyphenyl)1,1,1,3,3,3-hexafluoropropane, and the like;
di(hydroxyphenyl)sulfones such as
bis-(4-hydroxy-phenylsulfone),
2,4'-dihydroxydiphenyl sulfone,
5-chloro-2,4'-dihydroxydiphenyl sulfone,
5'-chloro-4,4'-dihydroxydiphenyl sulfone, and the like;
di(hydroxyphenyl) ethers such as
bis-(4-hydroxyphenyl)ether,
the 4,3'-, 4,2'-, 2,2'-, 2,3'-, dihydroxyphenyl ethers,
4,4'-dihydroxy-2,6-dimethyldiphenyl ether,
bis-(4-hydroxy-3-isobutylphenyl) ether,
bis-(4-hydroxy-3-isopropylphenyl) ether,
bis-(4-hydroxy-3-chlorophenyl) ether,
bis-(4-hydroxy-3-fluorophenyl) ether,
bis-(4-hydroxy-3-bromophenyl) ether,
bis-(4-hydroxynaphthyl) ether,
bis-(4-hydroxy-3-chloronaphthyl) ether, and
4,4'-dihydoxy-3,6-dimethoxydiphenyl ether.

As herein used the E term defined as being the "residuum of the dihydric phenol" of course refers to the residue of the dihydric phenol after the removal of the two aromatic hydroxyl groups. Thus as is readily seen these polyarylene polyethers contain recurring groups of the residuum of the dihydric phenol and the residuum of the benzenoid compound bonded through an aromatic ether oxygen atom.

Any dihalobenzenoid or dinitrobenzenoid compound or mixtures thereof can be employed in this invention, which compound or compounds has the two halogens or nitro-groups bonded to benzene rings having an electron withdrawing group in at least one of the positions ortho and para to the halogen or nitro group. The dihalobenzenoid or dinitrobenzenoid compound can be either mononuclear where the halogens or nitro groups are attached to the same benzenoid rings or polynuclear where they are attached to different benzenoid rings, as long as there is an activating electron withdrawing group in the ortho or para position of that benzenoid nucleus. Fluorine and chlorine substituted benzenoid reactants are preferred; the fluorine compounds for fast reactivity and the chlorine compounds for their inexpensiveness. Fluorine substituted benzenoid compounds are most preferred, particularly when there is a trace of water present in the polymerization reaction system. However, this water content should be maintained below about 1% and preferably below 0.5% for best results.

An electron withdrawing group can be employed as the activator group in these compounds. It should be, of course, inert under the reaction conditions, but otherwise its structure is not critical. Preferred are the strong activating groups such as the sulfone group

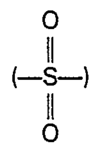

bonding two halogen or nitro substituted benzenoid nuclei as in the 4,4'-dichlorodiphenyl sulfone and 4,4'-difluorodiphenyl sulfone, although such other strong withdrawing groups hereinafter mentioned can also be used with equal ease.

The more powerful of the electron withdrawing groups give the fastest reactions and hence are preferred. It is further preferred that the ring contain no electron supplying groups on the same benzenoid nucleus as the halogen or nitro group; however, the presence of other groups on the nucleus or in the residuum of the compound can be tolerated. Preferably, all of the substituents on the benzenoid nucleus are either hydrogen (zero electron withdrawing), or other groups having a positive sigma* value, as set forth in J. F. Bunnett in Chem. Rev. 49 273 (1951) and Quart. Rev., *12,* 1 (1958). See also Taft, Steric Effects *in Organic Chemistry,* John Wiley & Sons (1956), chapter 13; *Chem. Rev.,* 53, 222; JACS, 74, 3120; and JACS, 75, 4231.

The activating group can be basically either of two types:

(a) monovalent groups that activate one or more halogens or nitro-groups on the same ring such as another nitro or halo group, phenylsulfone, or alkylsulfone, cyano, trifluoromethyl, nitroso, and hetero nitrogen, as in pyridine.

(b) divalent groups which can activate displacement of halogens on two different rings, such as the sulfone group

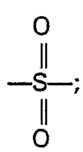 ; the carbonyl group 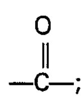 ; the vinylene group 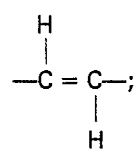 ; the sulfoxide group 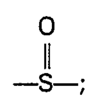 ;

the azo-group —N=N=; the saturated fluorocarbon groups $—CF_2CF_2—$; organic phosphine oxides

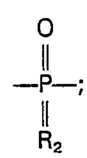

where $R_2$ is a hydrocarbon group, and the ethylidene group

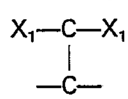

where $X_1$ can be hydrogen or halogen and activating groups within the nucleus which can activate halogens as nitro functions on the same ring such as in the case with difluorobenzoquinone, 1,4- or 1,5- or 1,8-difluoroanthraquinone, etc.

If desired, the polymers may be made with mixtures of two or more dihalobenzenoid or dinitrobenzenoid compounds. Thus, the E' residuum of the benzenoid compounds in the polymer structure may be the same or different.

It is seen also that as used herein, the E' term defined as being the "residuum of the benzenoid compound" refers to the aromatic or benzenoid residue of the compound after the removal of the halogen atom or nitro group on the benzenoid nucleus.

The polyarylene polyethers for use in this invention are prepared by methods well known in the art as for instance the substantially equimolar one-step reaction of a double alkali metal salt of dihydric phenol with a dihalobenzenoid compound in the presence of specific liquid organic sulfoxide or sulfone solvents under substantially anhydrous conditions. Catalysts are not necessary for this reaction.

The polymers may also be prepared in a two-step process in which a dihydric phenol is first converted *in situ* in the primary reaction solvent to the alkali metal salt of the reaction with the alkali metal, alkali metal hydride, alkali metal hydroxide, alkali metal alkoxide or the alkali metal alkyl compounds. Preferably, the alkali metal hydroxide is employed. After removing the water which is present or formed, in order to secure substantially anhydrous conditions, the dialkali metal salts of the dihydric phenol are admixed and reacted with about stoichiometric quantities of the dihalobenzenoid or dinitrobenzenoid compound.

The polymerization reaction proceeds in the liquid phase of a sulfoxide or sulfone organic solvent at elevated temperatures.

A preferred form of the poly(aryl ether) for use in this invention are those prepared using the dihydric polynuclear phenols of the following four types, including the derivatives thereof which are substituted with inert substituent groups

(a) 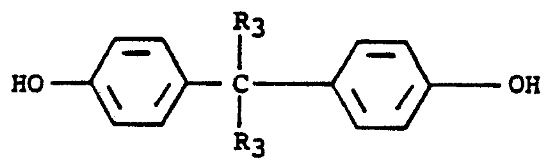

in which the $R_3$ group represents independently hydrogen, lower alkyl, aryl and the halogen substituted groups thereof, which can be the same or different;

(b) 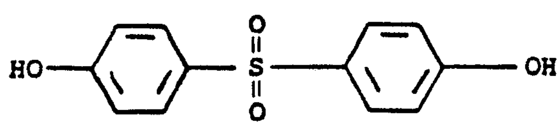

(c) 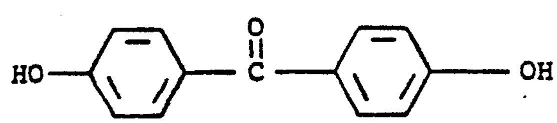

(d) 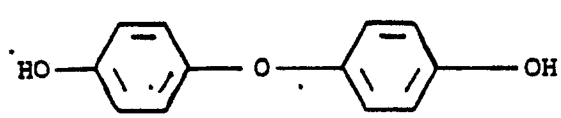

and substituted derivatives thereof.

It is also contemplated in this invention to use a mixture of two or more different dihydric phenols to accomplish the same ends as above. Thus when referred to above the —E— residuum in the polymer structure can actually be the same or different aromatic residua.

In order to secure the high polymers, the system should be substantially anhydrous, and preferably with less than 0.5 per cent by weight water in the reaction mixtures.

The poly(aryl ether)s have a reduced viscosity of from about 0.35 to about 1.5 as measured in an appropriate solvent at an appropriate temperature depending on the particular poly(aryl ether), such as in methylene chloride at 25°C.

The preferred poly(aryl ether)s have repeating units of the formula:

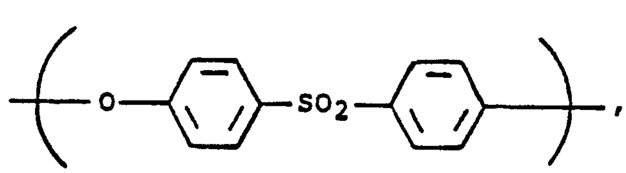

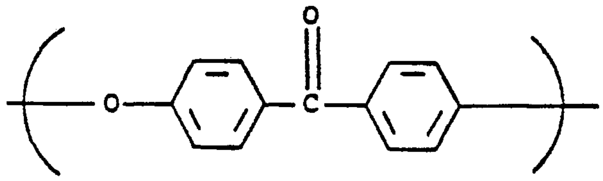,

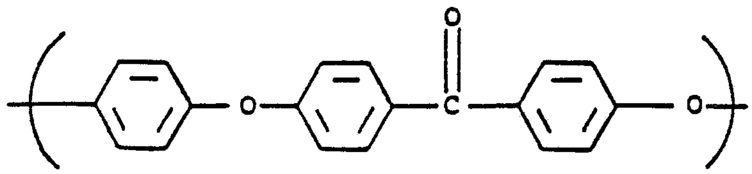 and

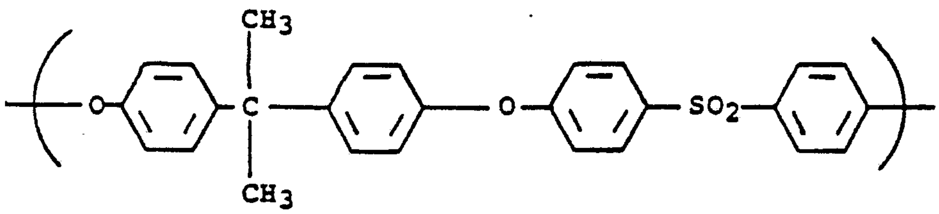

The poly(etherimide) polymers suitable for use in this invention are known in the art and are described in, for example, U.S. Patents 3,847,867, 3,838,097 and 4,107,147.

The poly(etherimide) polymers are of the following formula:

(I) 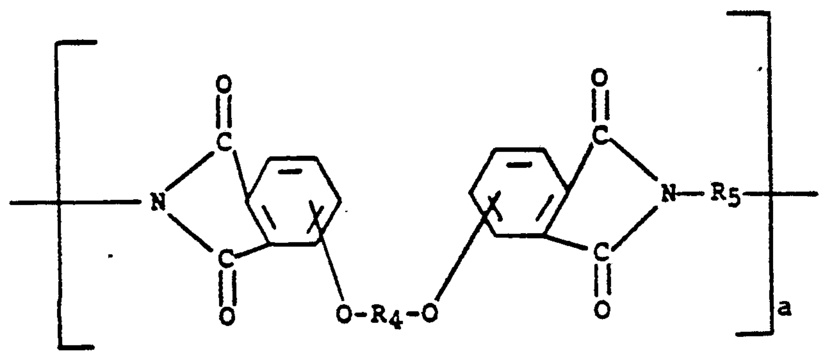

wherein a is an integer greater than 1, preferably from about 10 to about 10,000 or more, —O—$R_4$—O— is attached to the 3 or 4 and 3′ or 4′ positions and $R_4$ is selected from (a) a substituted or unsubstituted aromatic radical of the formula:

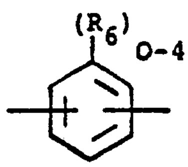, or 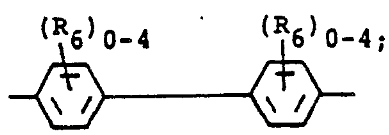

(b) a divalent radical of the formula:

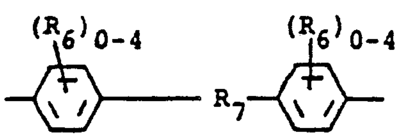

wherein $R_6$ is independently $C_1$ to $C_6$ alkyl, or halogen and $R_7$ is selected from —O—, —S—,

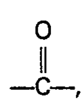,

—SO—, —$SO_2$— alkylene of 1 to 6 carbon atoms, cycloalkylene of 4 to 8 carbon atoms, alkylidene of 1 to 6

carbon atoms or cycloalkylidene of 4 to 8 carbon atoms, $R_5$ is selected from an aromatic hydrocarbon radical having from 6—20 carbon atoms and halogenated derivatives thereof, or alkyl substituted derivatives thereof, wherein the alkyl group contains 1 to 6 carbon atoms, alkylene and cycloalkylene radicals having from 2 to 20 carbon atoms, $C_2$—$C_8$ alkylene terminated polydiorganosiloxane and a divalent radical of the formula

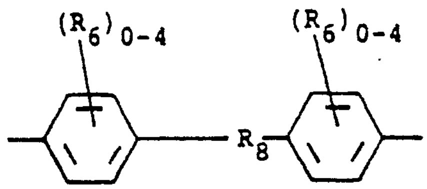

wherein the $R_6$'s are as previously defined, and $R_8$ may be a direct bond.

(II) 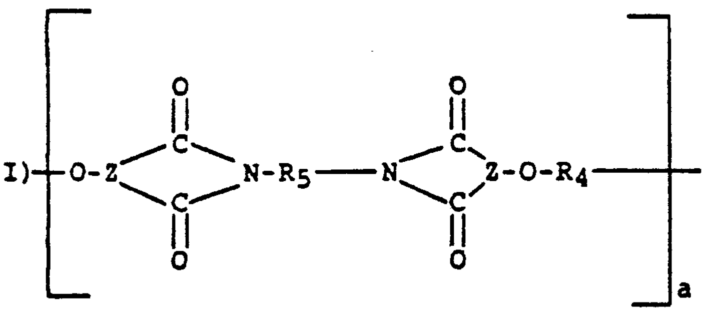

wherein —O—Z is a member selected from

(a) 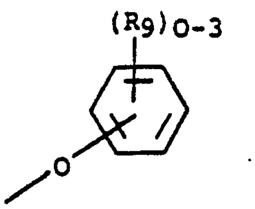

wherein $R_9$ is independently hydrogen, lower alkyl or lower alkoxy

(b) 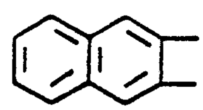 and, 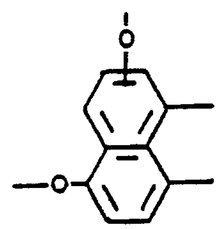 (c)

wherein the oxygen may be attached to either ring and located ortho or para to one of the bonds of the imide carbonyl groups, $R_4$ and $R_5$ and a are as previously defined.

These polyetherimides are prepared by methods well known in the art as set forth in, for example, U.S. Patents 3,833,544, 3,887,588, 4,017,511, 3,965,125 and 4,024,110.

The polyetherimides of Formula (I) can, for example, be obtained by any of the methods well-known to those skilled in the art including the reaction of any aromatic bis(ether anhydride)s of the formula

(III) 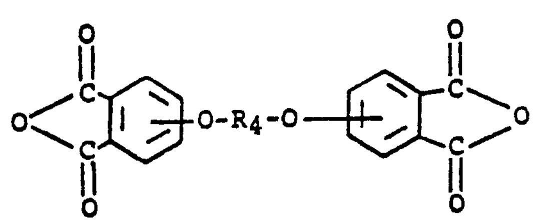

where $R_4$ is as defined hereinbefore, with a diamino compound of the formula

(IV) $H_2N—R_5—NH_2$

where $R_5$ is as defined hereinbefore. In general, the reactions can be advantageously carried out employing well-known solvents, e.g., o-dichlorobenzene, m-cresol/toluene, N,N-dimethylacetamide, etc., in which to effect interaction between the dianhydrides and diamines, at temperatures of from about 20 to about 250°C. Alternatively, the polyetherimides can be prepared by melt polymerization of any dianhydride of Formula III with any diamino compound of Formula IV while heating the mixture of the ingredients at elevated temperatures with concurrent intermixing. Generally, melt polymerization temperatures between about 200° and 400°C and preferably 230° to 300°C can be employed. Any order of addition of chain stoppers ordinarily employed in melt polymerization can be employed. The conditions of the reaction and the proportions of ingredients can be varied widely depending on the desired molecular weight, intrinsic viscosity, and solvent resistance. In general, equimolar amounts of dimaine and dianhydride are employed for high molecular weight polyetherimides, however, in certain instances, a slight molar excess (about 1 to 5 mole percent) of diamine or dianhydride can be employed. The poly(etherimide) polymers of Formula I have an intrinsic viscosity [η] greater than 0.2 deciliters per gram, preferably 0.35 to 0.60, or 0.7 deciliters per gram or even higher when measured in m-cresol at 25°C.

The aromatic bis(ether anhydride)s of Formula III include, for example,
2,2-bis[4-(2,3-dicarboxyphenoxy)phenyl]propane dianhydride;
4,4'-bis(2,3-dicarboxyphenoxy)diphenyl ether dianhydride;
1,3-bis(2,3-dicarboxyphenoxy)benzene dianhydride;
4,4'-bis(2,3-dicarboxyphenoxy)diphenyl sulfide dianhydride;
1,4-bis(2,3-dicarboxyphenoxy)benzene dianhydride;
4,4'-bis(2,3-dicarboxyphenoxy)benzophenone dianhydride;
4,4'-bis(2,3-dicarboxyphenoxy)diphenyl sulfone dianhydride;
2,2-bis[4-(3,4-dicarboxyphenoxy)phenyl]propane dianhydride;
4,4'-bis(3,4-dicarboxyphenoxy)diphenyl ether dianhydride;
4,4'-bis(3,4-dicarboxyphenoxy)diphenyl sulfide dianhydride;
1,3-bis(3,4-dicarboxyphenoxy)benzene dianhydride;
1,4-bis(3,4-dicarboxyphenoxy)benzene dianhydride;
4,4'-bis(3,4-dicarboxyphenoxy)benzophenone dianhydride;
4-(2,3-dicarboxyphenoxy)-4'-(3,4-dicarboxyphenoxy)diphenyl-2,2-propane dianhydride; etc. and mixtures of such dianhydrides.

The organic diamines of Formula IV include, for example, m-phenylenediamine, p-phenylenediamine, 4,4'-diaminodiphenylpropane, 4,4'-diaminodiphenylmethane, benzidine, 4,4'-diaminodiphenyl sulfide, 4,4'-diaminodiphenyl sulfone, 4,4'-diaminodiphenyl ether, 1,5-diaminonaphthalene, 3,3'-dimethylbenzidine and, 3,3'-dimethoxybenzidine.

The polyetherimides of formula (II) may, for example, be prepared by affecting reaction in the presence of a dipolar aprotic solvent of a mixture of ingredients comprising, for instance, (1) a bis(nitrophthalimide) of the general formula:

(V) 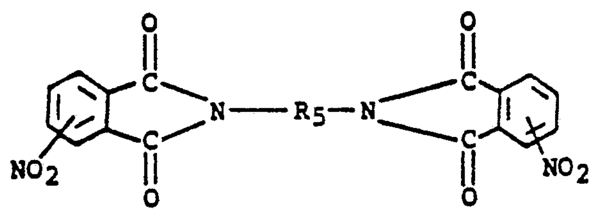

wherein $R_5$ is defined as hereinabove, and (2) an alkali metal salt of an organic compound of the general formula:

(VI) $$MO—R_4—OM$$

wherein M is an alkali metal and $R_4$ is defined as hereinabove.

The bis(nitrophthalimide) used in preparing the polymer is formed by reaction a diamine of the formula described above, $NH_2—R_4—NH_2$, with a nitro-substituted aromatic anhydride of the formula:

(VII) 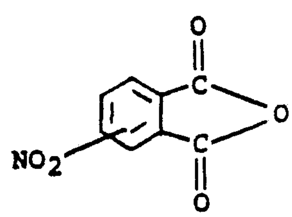

The molar ratio of diamine to anhydride should ideally be about 1:2 respectively. The initial reaction product is a bis(amide-acid) which is subsequently dehydrated to the corresponding bis(nitrophthalimide).

The diamines are described, *supra.*

The preferred nitrophthalic anhydrides useful herein are 3-nitrophthalic anhydride, 4-nitrophthalic anhydride, and mixtures thereof. These reactants are commercially available in reagent grade. They may also be prepared by the nitration of phthalic anhydride using procedures described in Organic Synthesis, Collective Vol. I, Wiley (1948), page 408. Certain other closely related nitroaromatic anhydrides may also be used in the reaction and are illustrated for example by 2-nitrophthalic anhydride, 1-nitro-2,3-naphthalenedicarboxylic acid anhydride, 3-methoxy-6-nitrophthalic anhydride, and the like.

With reference to the alkali metal salts of formula VI among the divalent carbocyclic aromatic radicals which $R_4$ may represent (mixtures of such radicals are also included) are, for instance, divalent aromatic hydrocarbon radicals of from 6 to 20 carbon atoms, such as phenylene, biphenylene, naphthylene, etc. Included are residues of, e.g. hydroquinone, resorcinol, chlorohydroquinone, etc. In addition, $R_4$ may be a residue of a dihydroxy diarylene compound in which the aryl nuclei are joined by either an aliphatic group, a sulfoxide group, sulfonyl group, sulfur, carbonyl group, oxygen, the $—C(CH_3)(CH_2)_2(COOH)$ group, etc. Typical of such diarylene compounds are the following:

2,4-dihydroxydiphenylmethane;
bis(2-hydroxyphenyl)methane;
2,2-bis(4-hydroxyphenyl)propane;
bis(4-hydroxyphenyl)methane;
bis(4-hydroxy-5-nitrophenyl)methane;
bis(4-hydroxy-2,6-dimethyl-3-methoxyphenyl)methane;
1,1-bis(4-hydroxyphenyl)ethane;
1,2-bis(4-hydroxyphenyl)ethane;
1,1-bis(4-hydroxy-2-chlorophenyl)ethane;
1,1-bis(2,5-dimethyl-4-hydroxyphenyl)ethane;
1,3-bis(3-methyl-4-hydroxyphenyl)propane;
2,2-bis(3-phenyl-4-hydroxyphenyl)propane;
2,2-bis(3-isopropyl-4-hydroxyphenyl)propane;
2,2-bis(4-hydroxynaphthyl)propane;
hydroquinone;
naphthalene diols;
bis(4-hydroxyphenyl)ether;
bis(4-hydroxyphenyl)sulfide;
bis(4-hydroxyphenyl)sulfone; and the like.

When dialkali metal salts of formula VI are used with the compound illustrated by formula V, the ingredients are advantageously present in an equal molar ratio for optimum molecular weight and properties of the polymer. Slight molar excesses, e.g., about 0.001 to 0.10 molar excess of either the dinitro-substituted organic compound or of the dialkali metal salt of formula VI may be employed. When the molar ratios are approximately equal, the polymer is substantially terminated by $Z—NO_2$ at one end and a phenolic group at the other end. If there is a molar excess of one compound, that particular terminal group will predominate.

The conditions of reaction whereby the alkali-metal salt of formula VI is reacted with the dinitro-substituted organic compound of formula V can be varied widely. Generally, temperatures of the order of about 25—150°C are advantageously employed, although it is possible to employ lower or higher temperature conditions depending of the ingredients used, the reaction product sought, time of reaction, solvent employed, etc. In addition to atmospheric pressure, superatmospheric pressures and subatmospheric pressures may be employed depending upon the other conditions of reaction, the ingredients used, the speed at which it is desired to effect reaction, etc.

The time of reaction also can be varied widely depending on the ingredients used, the temperature, the desired yield, etc. It has been found that times varying from about 5 minutes to as much as 30 to 40 hours are advantageously employed to obtain the maximum yield and desired molecular weight. Thereafter the reaction product can be treated in the appropriate manner required to effect precipitation and/or separation of the desired polymeric reaction product. Generally, common solvents such as alcohols (e.g. methanol, ethanol, isopropyl alcohol, etc.) and aliphatic hydrocarbons (e.g. pentane, hexane, octane, cyclohexane, etc.) may be employed as precipitants for this purpose.

It is important that the reaction between the dinitro-substituted organic compound of formula V and the alkali-metal salt of formula VI (mixtures of such alkali-metal salts can also be used) be carried out in the presence of a dipolar aprotic solvent.

The polymerization is performed under anhydrous conditions usually using dipolar aprotic solvents such as dimethylsulfoxide which are added in varying amounts depending upon the particular polymerization. A total quantity of solvent, dipolar aprotic solvent or mixture of such solvent with an aromatic solvent sufficient to give a final solution containing 10—20% by weight of polymer is preferably employed.

The preferred poly(etherimide) polymers include those having repeating units of the following formula:

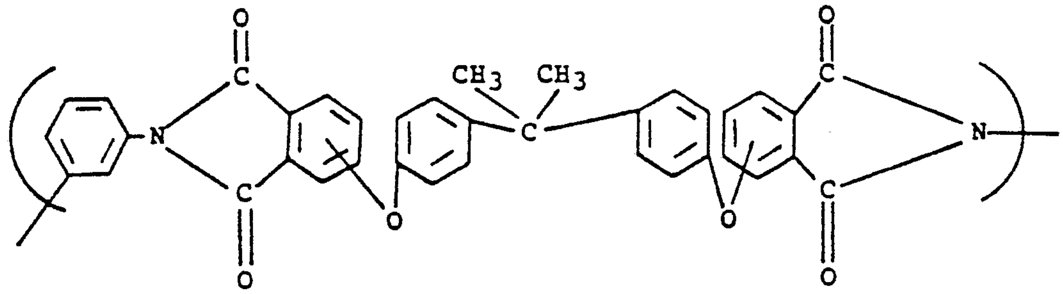

The fibers which are suitable for use in this invention are reinforcing fibers and include fiberglass, carbon fibers, aromatic polyamide fibers (such as aramid fibers sold by E. I. duPont de Nemours & Company, Wilmington, Delaware, under the trademark of Kevlar), and the like, or combinations thereof.

The carbon fibers include those having a high Young's modulus of elasticity and high tensile strength. These carbon fibers may be produced from pitch, as described in U.S. Patents 3,976,729; 4,005,183 and 4,026,788, for example.

The preferred fiber is fiberglass.

The fillers which are suitable for use in this invention include inorganic fillers such as Wollastonite, calcium carbonate, glass beads, talc, mica, and the like, or mixtures thereof.

The composition may contain other ingredients such as stabilizers, i.e. metal oxides such as zinc oxide, antioxidants, flame retardants, pigments, and the like.

The blends for the circuit board substrates of this invention are prepared by any conventional mixing methods. For example, a preferred method comprises mixing the poly(aryl ether), poly(etherimide) polymer, fiber and filler, and other optional ingredients in powder or granular form in an extruder and extruding the mixture into strands, chopping the strands into pellets and molding the pellets into the desired circuit board substrate.

The blends can be molded into circuit board substrates using conventional techniques. Specifically, the blends can be molded into circuit board substrates using conventional molding equipment. The molded boards are then swelled and etched to promote the adhesion of copper by both roughening the surface and introducing chemical moieties through oxidation. The circuitry is then applied to the board by either a conventional additive or a semiadditive process. In either case copper is applied to the substrate in an electroless manner after the application of catalysts which activate the surface to the deposition of metal in a conventional manner.

## Examples

The following Examples serve to give specific illustrations of the practice of this invention but they are not intended in any way to limit the scope of this invention.

### Control A

Control A was a poly(aryl ether) containing repeating units of the following formula:

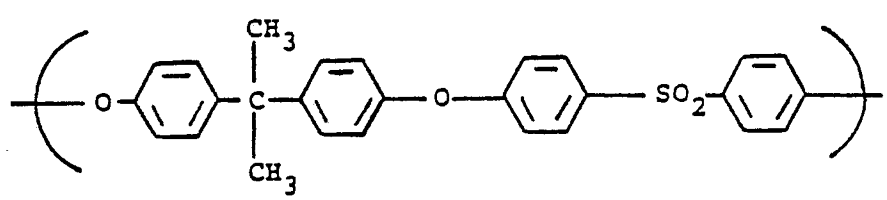

having a reduced viscosity of 0.43 as measured in chloroform (0.2 gram polymer in 100 ml at 25°C).

The poly(aryl ether) was compression molded at 300°C in a 10.16 × 10.16 × 0.051 cm (4 × 4 × 0.020) inch cavity mold using a heated hydraulic press. 0.32 cm (1/8 inch) strips were shear cut from the molded product. These strips were tested for 1% secant modulus according to a procedure similar to ASTM D—638; tensile strength and elongation at break according to ASTM D—638 and pendulum impact strength according to the following procedure:

A steel pendulum was used, cylindrical in shape with a diameter of 2.16 cm (0.85 inches) which weighed 709 g (1.562 pounds). The striking piece, mounted nearly at the top of the pendulum was a cylinder 0.76 cm (0.3 inches) in diameter. Film specimens, 10.16 cm (4 inches) long, 0.32 cm (0.125 inches) wide and about 25.4 to 508 µm (1 to 20 mils) thick were clamped between the jaws of the tester so that the jaws were spaced 2.54 cm (1 inch) apart. The 0.32 cm (0.125 inch) width of the film was mounted vertically. The pendulum was raised to a constant height to deliver 1.53 Nm (1.13 foot pounds) at the specimen. When the pendulum was released the cylindrical striking piece hit the specimen with its flat end, broke the film,

and traveled to a measured height beyond. The difference in the recovery height (i.e., the difference in the potential energy of the pendulum at the maximum point of the upswing) represents the energy absorbed by the specimen during rupture. The impact strength, expressed in $Nm/cm^3$ (foot-pounds per cubic inch), is obtained by dividing the pendulum energy loss by the volume of the specimen.

The results are shown in Table I.

The 1% secant modulus of the strips was also measured by the procedure as described above as a function of temperature from 22°C to 250°C.

The results are shown in the Figure. The Figure shows the modulus temperature characteristics of a poly(aryl ether), a poly(etherimide) and a blend of the two materials. The Figure shows that the modulus temperature characteristics of the blend is very similar to that of the poly(etherimide) and thus a circuit board made from the blend is wave solderable.

Control B

Control B was a poly(aryl ether) containing repeating units of the following formula:

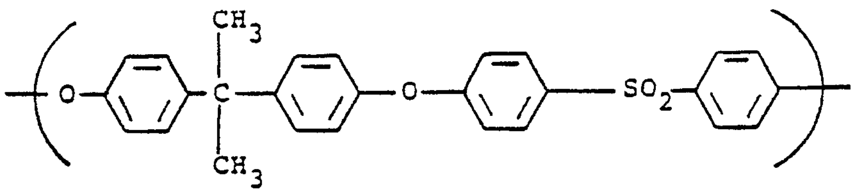

having a reduced viscosity of 0.51 as measured in chloroform at 25°C (0.2 gram polymer in 100 ml at 25°C).

The poly(aryl ether) was compression molded in a 10.16 × 10.16 × 0.051 cm (4 × 4 × 0.020 inch) cavity mold in a heated hydraulic press. 0.32 cm (1/8 inch) strips were shear cut from the molded product. The strips were placed in tension under a stress of 41 MPa (6000 psi) and wrapped with cotton swabs. The swabs were then saturated with a mixture of isopropanol, methanol, glycol ethers and organic acids such as is commonly used in solder fluxes. The times to rupture the strips at 25°C are shown in Table II. Additionally, 2.54 × 10.16 × 0.051 cm (1 × 4 × 0.020 inch) strips were plated with copper according to the following procedure: Specimens were placed in a 90%/10% by weight mixture of N,N'-dimethylformamide and sulfuric acid for 30 minutes at 25°C. Samples were removed, rinsed with cold tap water and placed in an etchant containing the following ingredients:

| | |
|---|---|
| 30.7 | water |
| 3.0 | chromium oxide |
| 10.4 | phosphoric acid |
| 55.9 | sulfuric acid |
| 100% | by weight |

Specimens were processed in the etchant for five minutes at 70°C. The specimens were then plated with copper to a thickness of 0.1 mm (0.004 inches) using standard techniques for plating on plastics. Copper was then removed from the edges of the specimens by sanding and the force per unit width required to peel the copper back was measured. The results are shown in Table III.

Control C

Control C was a poly(etherimide) containing repeating units of the following formula:

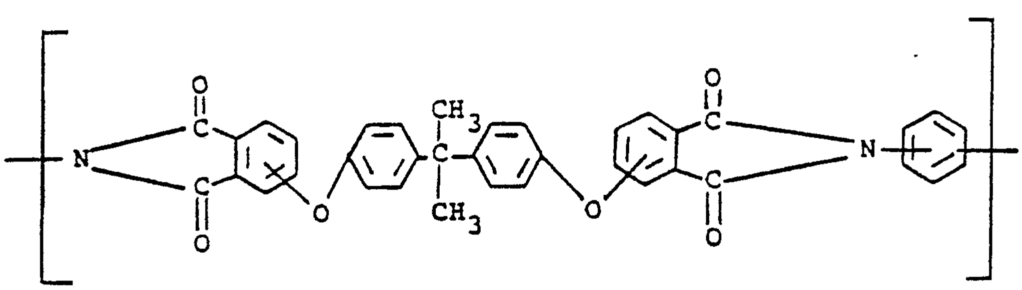

having a reduced viscosity of 0.51 as measured in chloroform (0.5 gram polymer in 100 ml at 25°C). It was compression molded and tested by the procedure as described in Controls A and B.

The results are shown in Tables I, II and III, and in Figure I.

Example 1

60 weight percent of the poly(etherimide) of Control C was blended with 40 weight percent of the poly(aryl ether) of Control A in a Brabender blender at about 325°C. The blend was compression molded at 325°C and tested, as described in Control A.

The results are shown in Table I and Figure I.

Example 2

60 weight percent of the poly(etherimide) of Control C was blended with 40 weight percent of the poly(arylether) of Control B in a Brabender blender at about 325°C. The blend was compression molded at 325°C and tested, as described in Control B.

The results are shown in Tables II and III.

TABLE I

| Example | Description of the Composition Polymer* | wt.% | 1% Secant Modulus MPa (psi) | Tensile Strength MPa (psi) | Elongation at break (%) | Pendulum Impact Strength NM/cm$^3$ | (ft-lb/in$^3$) |
|---|---|---|---|---|---|---|---|
| Control A | PAE | 100 | 1496 (217,000) | 63,85 (9,260) | 44 | 11,6 | (140) |
| Control C | PEI | 100 | 2144 (311,000) | 89,6 (13,000) | 22 | 3,3 | ( 40) |
| 1 | PEI | 60 | 1862 (270,000) | 73,1 (10,600) | 9 | 9,3 | (113) |
| | PAE | 40 | | | | | |

* PAE = Poly(aryl ether)
PEI = Poly(etherimide)

TABLE II

Times to rupture at 41 MPa (6000 psi) and 25°C when subjected to solder flux

| Example | Description of the Composition Polymer* | wt.% | Seconds to rupture Isopropanol Based Flux | Methanol Based Flux |
|---|---|---|---|---|
| Control B | PAE | 100 | 90 | 15 |
| Control C | PEI | 100 | 31,000 | 360 |
| 2 | PEI | 60 | 360 | 65 |
| | PAE | 40 | | |

TABLE III

| Example | Description of the Composition Polymer* | wt.% | Peel Strength Nm/cm (ft-lb./in) |
|---|---|---|---|
| Control B | PAE | 100 | 1 (2) |
| Control C | PEI | 100 | <0,5 (<1) |
| 2 | PEI | 60 | 1 (2) |
| | PAE | 40 | |

* PAE = poly(aryl ether)
PEI = poly(etherimide)

Control D

60% by weight of the poly(aryl ether) of Control A was blended with 38% by weight of wollastonite (Nyad 400, obtained from Nyco, a division of Processed Minerals, Inc.) and 2% of zinc oxide in a twin screw extruder at approximately 380°C.

This blend was used as a masterbatch in subsequent experiments.

Control E

A blend of 79% by weight of the poly(aryl ether) of Control A with 20% by weight of wollastonite (Nyad 400) and 1% by weight of zinc oxide was prepared by extrusion blending in a single screw 2.54 cm (1 inch) diameter extruder with L/D = 36/1 at 300—320°C. The extrudate was chopped into pellets. The pellets were injection molded into ASTM test bars (at 300—400°C) using a Newburg 7.8 g (1/4 ounce) screw injection molding machine. The test bars were measured for the following properties: tensile strength and modulus according to ASTM D—638; notched izod impact strength according to ASTM D—256 and tensile impact strength according to ASTM D—1822.

The pellets were also compression molded in a 10.16 × 10.16 × 0.051 cm (4 × 4 × 0.020 inch) cavity mold at 300—325°C in a heated hydraulic press. The plaques were cut into 2,54 × 10.16 × 0.051 cm (1 × 4 × 0.020 inch) strips which were plated with copper according to the following procedure. The strips were placed in a mixture of 77% water and 23% Shipley PM921 conditioner (to give a total of 100% by volume) at 54—57°C (130—135°F) for 2 minutes. Strips were removed, rinsed and placed in an etchant containing 1 kilogram of chromium oxide per liter of water at 60—63°C (140—145°F) for five minutes. The strips were then plated with copper to a thickness of 25.4—50.8 µm (0.001—0.002 inches) using standard techniques for plating on plastics. Copper peel strengths were then measured as in Control B.

The results are shown in Table 4.

Control F

79% by weight of the poly(etherimide) of Control C was blended with 20% by weight of wollastonite (Nyad 400) and 1% by weight of zinc oxide in a single screw 2.54 cm (1 inch) diameter extruder with L/D = 36/1 at 300—320°C. The extrudate was chopped into pellets. The pellets were injection molded into ASTM bars and tested as described in Control E. The pellets were also compression molded, plated with copper and tested as described in Control E.

The results are shown in Table 4.

Example 3

50% by weight of Control D was blended with 50% by weight of the poly(etherimide) of Control C in a single screw 2.54 cm (1 inch) diameter extruder with L/D = 36/1 at 300—320°C. The extrudate was chopped into pellets. The pellets were injection molded into ASTM test bars and tested as described in Control E. The pellets were also compression molded, plated with copper and tested as described in Control E.

The results are shown in Table 4.

Control G

A blend containing 65% by weight of the poly(etherimide) of Control C, 15% by weight of fiberglass, 19% by weight of wollastonite (Nyad 400) and 1% by weight of zinc oxide was prepared in a single screw 2.54 cm (1 inch) diameter extruder with L/D = 36/1 at 300—320°C. The extrudate was chopped into pellets. The pellets were compression molded in a 10.16 × 10.16 × 0.051 cm (4 × 4 × 0.020 inch) cavity mold at 325°C in a heated hydraulic press. The molded plaque was cut into strips, plated with copper and the copper peel strength measured as described in Control E.

The results are shown in Table 5.

Control H

A blend containing 35% by weight of the poly(aryl ether) of Control B, 30% by weight of the poly(aryl ether) of Control A, 15% by weight of fiber glass, 19% by weight of Wollastonite (Nyad 400) and 1% zinc oxide was prepared by blending in a 2.54 cm (one inch) diameter single screw extruder with L/D = 36/1 at 300—320°C. The extrudate was chopped into pellets. The pellets were compression molded in a 10.16 × 10.16 × 0.051 cm (4 × 4 × 0.020 inch) cavity mold at 323°C in a heated hydraulic press. The molded plaque was cut into strips, plated with copper and the peel strength measured as described in Control E.

The results are shown in Table 5.

Example 4

A 50/50 blend of pellets containing 70% by weight of the poly(etherimide) of Control C and 30% by weight of fiberglass and pellets of Control D was prepared in a single screw 2.54 cm (1 inch) in diameter extruder with L/D = 36/1 at 300—320°C. The extrudate was chopped into pellets and compression molded in a 10.16 × 10.16 × 0.051 cm (4 × 4 × 0.020 inch) cavity mold at 325°C. The molded plaque was cut into strips, plated with copper and the copper peel strength measured as in Control E.

The results are shown in Table 5.

TABLE 4

| Example | Description of the composition: Ingredients* | Wt.% | Tensile Modulus (psi) MPa | Tensile Strength (psi) MPa | Notched Izod 0,32 cm (1/8*) bar (ft/lb/in) Nm/cm | Tensile Impact (ft.lb/in$^2$) Nm/cm$^2$ | Peel Strength (lb/in$^2$) N/cm$^2$ |
|---|---|---|---|---|---|---|---|
| Control E | PAE<br>Nyad 400<br>Zinc Oxide | 79<br>20<br>1 | 3668<br>(532,000) | 68,05<br>( 9,870) | 0,59 (1.1) | 5,54 (26.4) | <0,7 (<1.0) |
| Control F | PEI<br>Nyad 400<br>Zinc Oxide | 79<br>20<br>1 | 4192<br>(608,000) | 93,8<br>(13,600) | 0,37 (0.7) | 2,52 (12.0) | <0,7 (<1.0) |
| 3 | PEI<br>PAE<br>Nyad 400<br>Zinc Oxide | 50<br>30<br>19<br>1 | 4158<br>(603,000) | 91,0<br>(13,200) | 0,72 (1.35) | 4,62 (22.0) | 0,9 (1.3) |

* PAE = poly(aryl ether)
PEI = poly(etherimide)

TABLE 5

| Example | Description of the composition: Ingredients* | Wt.% | Peel Strength (ft-lbs/in) Nm/cm |
|---|---|---|---|
| Control G | PEI | 65 | 0,3—1,3 |
| | Fiberglass | 15 | (0.5—2.5) |
| | Nyad 400 | 19 | |
| | Zinc Oxide | 1 | |
| Control H | PAE | 65 | <0,5 |
| | Fiberglass | 15 | (<1.0) |
| | Nyad 400 | 19 | |
| | Zinc Oxide | 1 | |
| 4 | PEI | 35 | 0,3—3,0 |
| | PAE | 30 | (0.5—5.0) |
| | Fiberglass | 15 | |
| | Nyad 400 | 19 | |
| | Zinc Oxide | 1 | |

* PAE = poly(aryl ether)
PEI = poly(etherimide)

In the above formulae lower alkyl is preferably $C_{1-6}$ alkyl, e.g. methyl, ethyl, n-propyl, i-propyl, n-butyl, i-butyl, sec.butyl, tert.-butyl, pentyl, i-pentyl, hexyl.

Cycloalkyl with 4—8 C-atoms is e.g. cyclobutyl, cyclopentyl, cyclohexyl, cycloheptyl, cyclooctyl, methylcyclopentyl or -hexyl etc.

Cycloalkylene residues are the corresponding divalent residues as cyclohexylene and cycloalkylidene divalent residues as above containing an ethylenically unsaturation as cyclohexylidene.

Halogen is Cl, Br, F and I.

Alkoxy is preferably $C_{1-6}$ alkoxy wherein alkyl is defined as above;

Alkylidene with 1 to 8 atoms is straight or branched and may contain 1, 2, 3, 4, 5, 6, 7 or 8 C-atoms, the same applies for corresponding residues with 1 to 6 C-atoms; aromatic residues with 6 to 20 C-atoms are e.g. derivatives of benzene or naphthalene or diphenyl, which may contain 1, 2, 3 or 4 of the stated substituents.

**Claims**

1. A circuit board substrate comprising a blend of 10 to 60 weight percent of a poly(aryl ether) and 40 to 90 weight percent of poly(etherimide) polymer.

2. A circuit board substrate as defined in claim 1 which contains 5 to 40 weight percent of a fiber and/or 15 to 40 weight percent of a filler.

**Patentansprüche**

1. Substrat für Schaltkreisplatten, das eine Mischung aus 10 bis 60 Gew.-% eines Poly(arylethers) und 40 bis 90 Gew.-% eines Poly(etherimid)-polymers umfaßt.

2. Substrat für Schaltkreisplatten nach Anspruch 1, das 5 bis 40 Gew.-% einer Faser und/oder 15 bis 40 Gew.-% eines Füllmittels enthält.

**Revendications**

1. Substrat destiné aux plaquettes de circuits imprimés, comprenant un mélange de 10 à 60% en poids d'un poly(éther d'aryle) et de 40 à 90% en poids d'un polymère du type poly(étherimide).

2. Substrat destiné aux plaquettes de circuits imprimés suivant la revendication 1, qui renferme 5 à 40% en poids d'une fibre et/ou 15 à 40% en poids d'une charge.

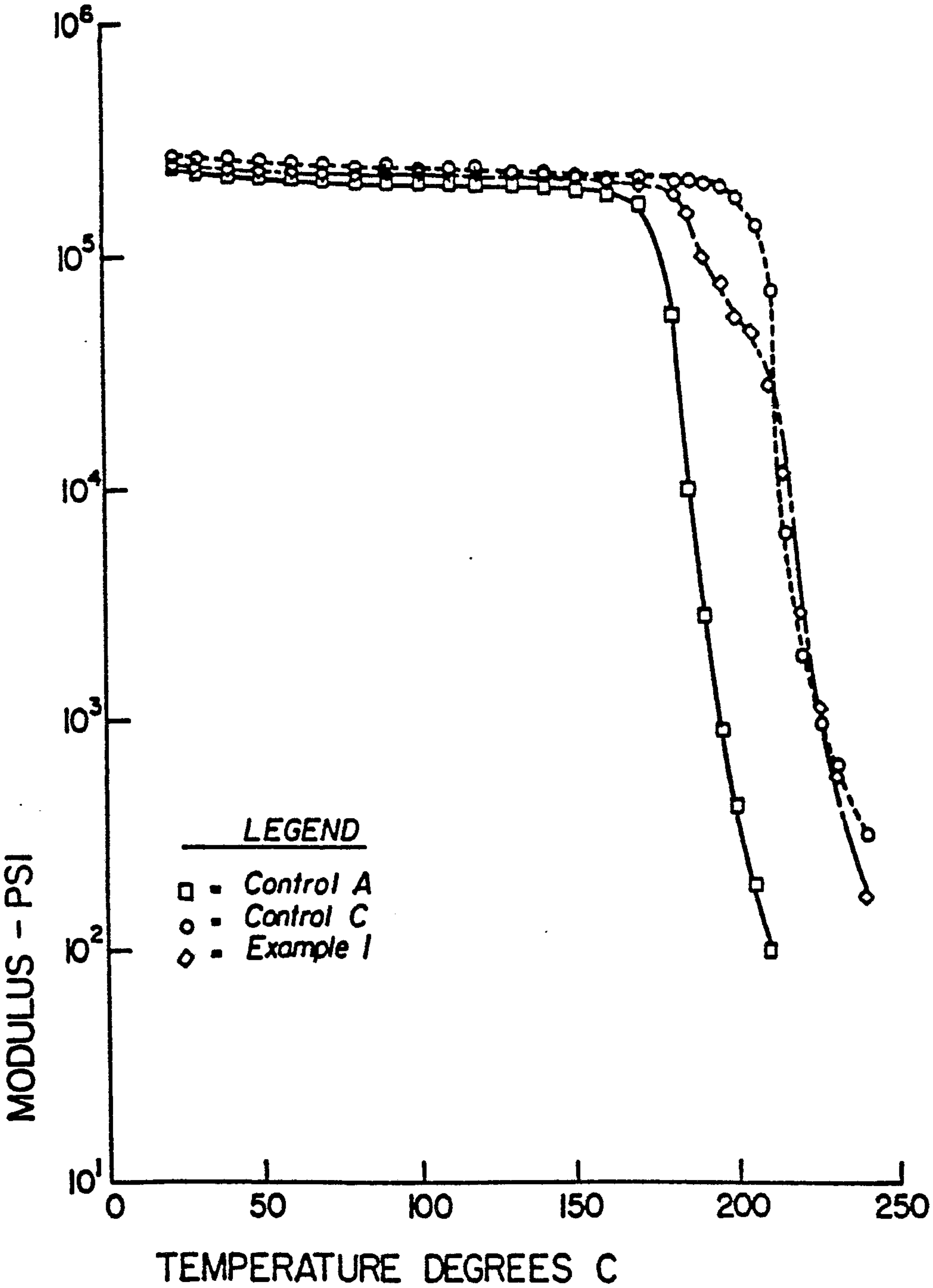

MODULUS - PSI
$10^6$
$10^5$
$10^4$
$10^3$
$10^2$
$10^1$
0
50
100
150
200
250
TEMPERATURE DEGREES C
LEGEND
□ = Control A
○ = Control C
◇ = Example I